# EUROPEAN PATENT APPLICATION

(11) **EP 3 965 173 A1**
(43) Date of publication of application: **09.03.2022**
(21) Application number: 20831159.7
(22) Date of filing: 01.05.2020
(51) Int. Cl.: H01L 33/46, H01L 33/54, H01L 33/56, H01L 33/58, H01S 5/022

(54) **LIGHT-EMITTING DEVICE AND METHOD FOR MANUFACTURING SAME**

(30) Priority: 25.06.2019 JP 2019116878
(71) Applicant: Toyoda Gosei Co., Ltd., Kiyosu-shi, Aichi 452-8564 (JP)
(72) Inventor: TAKEDA, Shigeo, Kiyosu-shi, Aichi 452-8564 (JP); KOKETSU, Masashi, Kiyosu-shi, Aichi 452-8564 (JP); SHIMONISHI, Shota, Kiyosu-shi, Aichi 452-8564 (JP)
(74) Representative: Kramer Barske Schmidtchen Patentanwälte PartG mbB
(86) International application number: PCT/JP2020/018425
(87) International publication number: WO 2020/261766

(57) **Abstract**

Provided is a light-emitting device 1 provided with: a substrate 10; a light-emitting element 13 that has a DBR film 14 and that is mounted on the substrate 10; a light-reflective film 16 provided on a surface of the substrate 10; and a sealing member 17 that is a lens-shaped potting-molded article for sealing the light-emitting element 13 and that is provided on the substrate 10 so that an edge of the bottom surface of the sealing member 17 contacts the upper surface of the light-reflective film 16, wherein a contact angle θ between the sealing member 17 and the upper surface of the light-reflective film 16 is greater than or equal to 40°.

## Description

### Technical Field

The present invention relates to a light-emitting device and a method for manufacturing the same.

### Background Art

Alight-emitting device is known which has wide light distribution characteristics to reduce the thickness of a backlight used in liquid-crystal-display televisions or general lighting fixtures, etc. (see, e.g., Patent Literature 1).

Where the light-emitting device having the wide light distribution characteristics is used as a light source for a lighting device in which plural light sources are arranged, uniformity of brightness of a light-emitting surface can be maintained even if the distance between the light-emitting surface and the light source is reduced. The thickness of the lighting device thereby can be reduced.

The light-emitting device described in Patent Literature 1 is configured so as to have batwing light distribution characteristics with emission intensity peaks on large-angle sides by disposing a dielectric multilayer film to reduce brightness directly above a light-emitting element on a light-emitting element and sealing the light-emitting element with a lens-shaped sealing member. The lens-shaped sealing member described in Patent Literature 1 is formed by a compression molding, an injection molding, or a dropping etc.

### Citation List

### Patent Literature

Patent Literature 1: JP 2017/73 549 A

### Summary of Invention

### Technical Problem

Of methods for forming the lens-shaped sealing member, a dropping (or potting) advantageous in the forming speed is excellent in productivity of the light-emitting device. In the dropping, however, it is difficult to control the shape of the resin as compared to other methods. Therefore, it is difficult to obtain desired light distribution characteristics when the sealing member is formed by the dropping.

It is an object of the invention to provide a light-emitting device which has batwing light distribution characteristics and in which the sealing member of the light-emitting element formed by the dropping has a shape suitable for obtaining the batwing light distribution characteristics, as well as a method for manufacturing the light-emitting device.

### Solution to Problem

To achieve the above object, according to an embodiment of the invention, a light-emitting device defined by (1) to (5) below and a method for manufacturing a light-emitting device defined by (6) to (10) below are provided.

(1) A light-emitting device, comprising:
   a substrate;
   a light-emitting element having a DBR film and being mounted on the substrate;
   a light-reflective film provided on a surface of the substrate; and
   a sealing member that comprises a lens-shaped dropping-formed article to seal the light-emitting element and is provided on the substrate so that an edge of a bottom surface is in contact with an upper surface of the light-reflective film,
   wherein a contact angle of the sealing member with the upper surface of the light-reflective film is not less than 40°.
(2) The light-emitting device according to (1) above, wherein the light-reflective film comprises a methyl silicone or a silane fluoride, and wherein the sealing member comprises a methyl phenyl silicone with a thixotropic index of not less than 5 in a state before curing, a phenyl silicone with a thixotropic index of not less than 3 in a state before curing, or an organo-modified silicone with a thixotropic index of not less than 2 in a state before curing.
(3) The light-emitting device according to (1) or (2) above, wherein, in a relationship between light distribution angle and emission intensity, emission intensity at the light distribution angle of 0° is not more than 90% of emission intensity at a largest peak.
(4) The light-emitting device according to any one of (1) to (3) above, wherein the contact angle is not more than 60°.
(5) The light-emitting device according to (4) above, wherein the sealing member comprises a methyl phenyl silicone with a thixotropic index of not less than 5 and not more than 7 in a state before curing, a phenyl silicone with a thixotropic index of not less than 3 and not more than 6 in a state before curing, or an organo-modified silicone with a thixotropic index of not less than 2 and not more than 5 in a state before curing.
(6) A method for manufacturing a light-emitting device, comprising:
   providing a substrate on which a light-emitting element having a DBR film is mounted and a light-reflective film is provided on a surface; and
   by dropping and curing a liquid resin on the substrate, forming a lens-shaped sealing member to seal the light-emitting element so that an edge of a bottom surface is in contact with the light-reflective film,
   wherein the liquid resin comprises a methyl phenyl silicone with a thixotropic index of not less than 5, a phenyl silicone with a thixotropic index of not less than 3, or an organo-modified silicone with a thixotropic index of not less than 2.
(7) The method for manufacturing a light-emitting device according to (6) above, wherein the liquid resin is heated to a temperature lower than a gelation temperature of the liquid resin by just before being dropped on the substrate, and wherein a temperature of the substrate from when the liquid resin is dropped onto the substrate to when it cures is not less than the gelation temperature of the liquid resin.
(8) The method for manufacturing a light-emitting device according to (7) above, wherein a temperature of the liquid resin just before being supplied onto the substrate is not less than 40°C and not more than 70°C.
(9) The method for manufacturing a light-emitting device according to (7) or (8) above, wherein the temperature of the substrate from when the liquid resin is dropped onto the substrate to when it cures is not more than 150°C.
(10) The method for manufacturing a light-emitting device according to any one of (6) to (9) above, wherein the liquid resin comprises a methyl phenyl silicone with a thixotropic index of not less than 5 and not more than 7, a phenyl silicone with a thixotropic index of not less than 3 and not more than 6, or an organo-modified silicone with a thixotropic index of not less than 2 and not more than 5.

### Advantageous Effects of Invention

According to the invention, a light-emitting device can be provided which has batwing light distribution characteristics and in which the sealing member of the light-emitting element formed by the dropping has a shape suitable for obtaining the batwing light distribution characteristics, as well as a method for manufacturing the light-emitting device.

### Brief Description of Drawings

FIG. 1 is a vertical cross-sectional view showing a light-emitting device in the first embodiment of the present invention.
FIG. 2 is a graph showing an example of wide batwing light distribution characteristics.
FIG. 3A is a vertical cross-sectional view showing a manufacturing process flow for the light-emitting device in the first embodiment of the invention.
FIG. 3B is a vertical cross-sectional view showing the manufacturing process flow for the light-emitting device in the first embodiment of the invention.
FIG. 3C is a vertical cross-sectional view showing the manufacturing process flow for the light-emitting device in the first embodiment of the invention.
FIG. 3D is a vertical cross-sectional view showing the manufacturing process flow for the light-emitting device in the first embodiment of the invention.
FIG. 4 is a schematic graph showing a relationship between temperature and viscosity of a thermosetting silicone resin in a state before curing.

### Description of Embodiments

### (Embodiment)

### (Configuration of a light-emitting device)

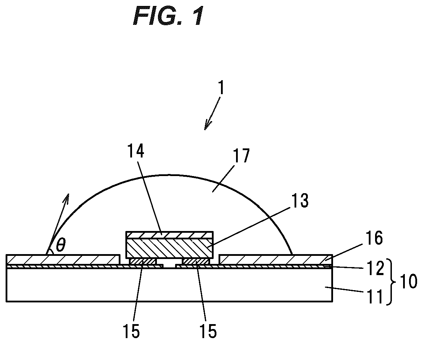

FIG. 1 is a vertical cross-sectional view showing a light-emitting device 1 in the first embodiment of the invention. The light-emitting device 1 includes a substrate 10, a light-emitting element 13 having a DBR film 14 and being mounted on the substrate 10, a light-reflective film 16 provided on a surface of the substrate 10, and a lens-shaped sealing member 17 that seals the light-emitting element 13 and is provided on the substrate 10 so that an edge of a bottom surface is in contact with the light-reflective film 16.

The substrate 10 has a plate-shaped base 11 and a wiring 12 formed on a surface of the base 11. The light-emitting element 13 is connected to the wiring 12 by conductive bonding members 15 formed of AuSn or solder, etc.

The light-emitting element 13 is, e.g., a light-emitting diode (LED) having a chip substrate and a crystal layer being provided on the chip substrate and including a light-emitting layer, and is, e.g., an LED with a chip size of 100 to 200 µm, called Mini LED. The mounting form of the light-emitting element 13 on the substrate 10 is not specifically limited, but is preferably flip-chip mounting as shown in FIG. 1 rather than face-up mounting since bonding members such as wires are not required and sealing at high speed is not impeded. Alternatively, the light-emitting element 13 may be a light-emitting element other than LED, such as laser diode (LD).

The DBR film 14 is provided on the light-emitting element 13 on the side opposite to the substrate 10 (on the upper side in FIG. 1). The DBR film 14 is composed of, e.g., a multilayer film of a dielectric such as SiO₂ and TiO₂. Light emitted from the light-emitting element 13 and extracted through the DBR film 14 has emission intensity peaks on large-angle sides.

The light-reflective film 16 is a member to reflect light which is emitted from the light-emitting element 13 and travels toward the substrate 10, and brightness of the light-emitting device 1 can be improved by using the light-reflective film 16. The light-reflective film 16 is formed of a methyl silicone or a silane fluoride.

The sealing member 17 is a dropping-formed article formed by curing a dropped resin, and is formed without using a dam. The sealing member 17 has a convex curved surface and serves as a lens to widen distribution of light emitted from the light-emitting element 13. The sealing member 17 is formed of a methyl phenyl silicone with a thixotropic index of not less than 5 in a state before curing, a phenyl silicone with a thixotropic index of not less than 3 in a state before curing, or an organo-modified silicone with a thixotropic index of not less than 2 in a state before curing.

Here, in light of the fact that a viscosity value of resin decreases according to a rotation speed, the thixotropic index used in the present embodiment is γ (γ>1) expressed by a value η_{b}/ηₐ of a ratio of a viscosity η_{b} at a rotation speed of 20 rpm with respect to a viscosity ηₐ at a rotation speed of 50 rpm. In this regard, for the methyl phenyl silicone, the phenyl silicone and the organo-modified silicone which are mentioned as the material of the sealing member 17, similar γ values are obtained also when ηₐ is a viscosity at a rotation speed of 60 rpm and η_{b} is a viscosity at a rotation speed of 30 rpm. These γ values are measured by the method described in JIS Z 8803 (2011).

A contact angle θ of the sealing member 17 with an upper surface of the light-reflective film 16 depends on the material of the sealing member 17, its thixotropic property in the state before curing, and the material of the light-reflective film 16 with which an edge of the sealing member 17 is in contact. It is easy to obtain the contact angle θ of not less than 40° when the light-reflective film 16 and the sealing member 17 are formed of the materials listed above. When not less than 40°, desired wide batwing light distribution characteristics can be obtained by combining with the light-emitting element 13 having the DBR film 14.

Here, the desired wide batwing light distribution characteristics mentioned above are light emission characteristics which have peaks between light distribution angles from 0 to ±90° and in which emission intensity at the light distribution angle of 0° is smaller than emission intensities at the peaks, and are light distribution characteristics in which, e.g., in a relationship between the light distribution angle and the emission intensity, the emission intensity at the light distribution angle of 0° is not more than 90% of the emission intensity at the largest peak. The light distribution angle is an angle with respect to an axial direction of the light-emitting device 1 (an upward direction in FIG. 1), in a plane which is perpendicular to the substrate 10 and includes the axial direction.

The light-emitting device 1 has wide batwing light distribution characteristics and is thus suitable for, e.g., a direct backlight used for a liquid-crystal-display television, etc. The thickness of the lighting device can be reduced by using the light-emitting device 1 as a light source since brightness of a light-emitting surface can be kept uniform even if a distance to the light-emitting surface is reduced.

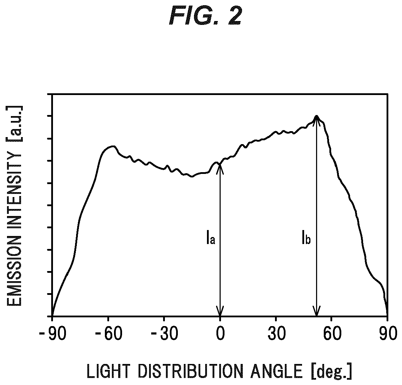

FIG. 2 is a graph showing an example of wide batwing light distribution characteristics. In the example shown in FIG. 2, an emission intensity Ia at the light distribution angle of 0° is about 76% of an emission intensity Ib at the largest peak.

Meanwhile, when the sealing member 17 is formed of a resin having such thixotropic properties that the contact angle θ of the sealing member 17 formed by the dropping method with the upper surface of the light-reflective film 16 becomes large, batwing light distribution characteristics is not obtained in some cases due to formation of a protrusion (horn) at an upper end of the sealing member 17 and resulting concentration of light on an axis at the light distribution angle of 0°. Therefore, the contact angle θ is preferably not more than 60°.

To prevent formation of the protrusion at the upper end at the time of dropping while ensuring that the contact angle θ is not more than 60°, it is preferable that the thixotropic index in the state before curing is not more than 7 when the sealing member 17 is formed of a methyl phenyl silicone, the thixotropic index in the state before curing is not more than not more than 6 when formed of a phenyl silicone, and the thixotropic index in the state before curing is not more than 5 when formed of an organo-modified silicone.

The sealing member 17 may contain a filler formed of SiO₂, etc., for scattering light or phosphor particles. The thixotropic property of the material of the sealing member 17 in the state before curing can be controlled by, e.g., adjusting a concentration of the filler contained in the sealing member 17.

### (Method for manufacturing the light-emitting device)

Next, an example of a method for manufacturing the light-emitting device 1 will be described.

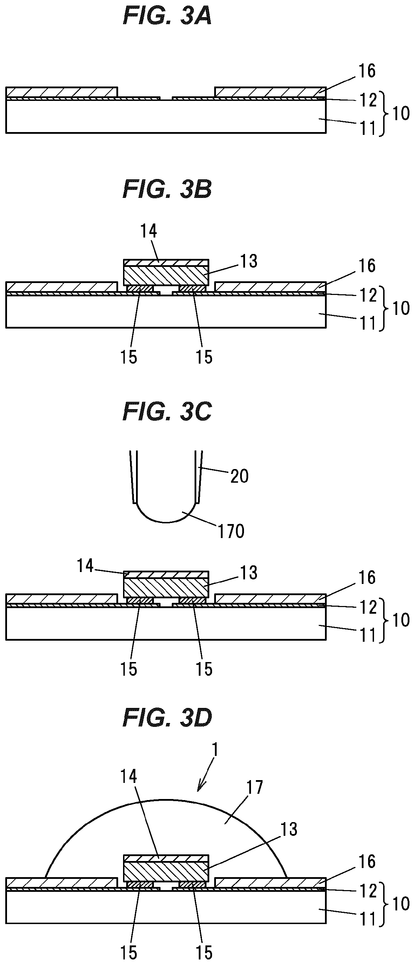

FIGS. 3A to 3D are vertical cross-sectional views showing a manufacturing process flow for the light-emitting device 1.

Firstly, the light-reflective film 16 is formed on the substrate 10, as shown in FIG. 3A. The light-reflective film 16 is formed by screen printing, etc.

Next, the light-emitting element 13 is mounted on the substrate 10, as shown in FIG. 3B. The light-emitting element 13 may be mounted before forming the light-reflective film 16 if it does not impede formation of the light-reflective film 16.

Next, the sealing member 17 is formed, as shown in FIGS. 3C and 3D. A liquid resin 170, which is the material of the sealing member 17, is dropped onto the substrate 10 from a nozzle 20 of a dropping device and is cured, and the sealing member 17 is thereby formed. An edge of the bottom surface of the sealing member 17 is in contact with the upper surface of the light-reflective film 16.

A methyl phenyl silicone with a thixotropic index of not less than 5, a phenyl silicone with a thixotropic index of not less than 3 or an organo-modified silicone with a thixotropic index of not less than 2 is used as the liquid resin 170 which is the material of the sealing member 17.

Here, to cure the liquid resin 170, a conventional method such as conveying and heating the substrate 10 in a furnace after dropping the resin 170 may be used, but by using a method for accelerating the curing of the resin 170 as described below, spreading of the resin 170 on the substrate 10 before it cures is suppressed, and the contact angle θ of the sealing member 17 with the upper surface of the light-reflective film 16 can be increased easily.

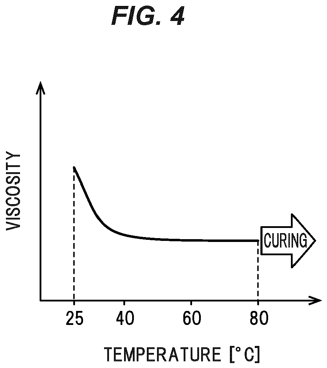

FIG. 4 is a schematic graph showing a relationship between temperature and viscosity of a thermosetting silicone resin in a state before curing.

Gelation temperature of silicone resin before curing is about 70 to 100°C regardless of the type of silicone resin (the gelation temperature in the example shown in FIG. 4 is 80°C). As shown in FIG. 4, viscosity simply decreases as the temperature approaches the gelation temperature from room temperature, crosslinking begins to occur when exceeding the gelation temperature, and curing begins.

The silicone resin has a low viscosity and easily spreads on the substrate until the temperature reaches the gelation temperature. Thus, when the silicone resin at room temperature is dropped and then starts to be heated on the substrate, it takes long time for the temperature to reach the gelation temperature and a spread amount of the silicone resin on the substrate increases.

Therefore, the temperature of the resin 170 which is the silicone resin is increased to a temperature lower than its gelation temperature by just before being supplied onto the substrate 10. In addition, the temperature of the substrate 10 from when the resin 170 is dropped onto the substrate 10 to when it cures is set to not less than the gelation temperature of the resin 170.

This reduces time from when the resin 170 is supplied onto the substrate 10 to when it reaches its gelation temperature, and the spread amount of the resin 170 on the substrate 10 can be thereby reduced. As a result, the contact angle θ of the sealing member 17 with the light-reflective film 16 can become easily not less than 40°.

Heating of the resin 170 before dropping is typically performed in the dropping device. In this case, for example, the temperature of the resin 170 just before being supplied onto the substrate 10 is the temperature of the resin 170 in a syringe of the dropping device.

In addition, to improve the discharge properties from the nozzle 20 of the dropping device, the temperature of the resin 170 just before being supplied onto the substrate 10 is preferably not less than 40°C, more preferably not less than 50°C.

When the temperature of the resin 170 just before being supplied onto the substrate 10 is not less than 40°C, a sufficient discharge rate can be obtained and it is possible to discharge the silicone resin, e.g., not less than 50 times per second. In other words, it is possible to discharge the silicone resin for fifty sealing members 17 in one second. Further, when the temperature of the resin 170 just before being supplied onto the substrate 10 is not less than 50°C, the viscosity of the resin 170 becomes a substantially lower limit and a higher discharge rate is obtained.

The effect of improving the speed of forming the sealing member 17 by improving the discharge rate of the resin 170 is very important in the manufacture of the light-emitting device 1 in which a large number of the light-emitting elements 13 are mounted, e.g., in the manufacture of a direct backlight, etc., in which several thousands of light-emitting elements 13 are mounted.

In addition, since the gelation temperature of the silicone resin is about 70 to 100°C as described above, the temperature of the resin 170 just before being supplied onto the substrate 10 is preferably not more than 70°C so that it does not exceed the gelation temperature before dropping. Furthermore, in case that a margin from the gelation temperature is required to improve productivity, the temperature of the resin 170 just before being supplied onto the substrate 10 is preferably not less than 10°C lower than the gelation temperature and is preferably not more than 60°C.

Time to curing of the resin 170 is shorter when the temperature of the substrate 10 from when the resin 170 is dropped onto the substrate 10 to when it cures is higher, but the temperature is preferably set within a range in which it does not has an adverse impact, such as damage or change of properties, on the sealing member 17 and other members. To suppress, e.g., discoloration of the base 11 formed of glass epoxy, it is preferably set to not more than 150°C.

An amount of the resin 170 per discharge, i.e., a discharge amount to form one sealing member 17 is preferably not less than 0.012 mm³ and not more than 1.527 mm³ by volume. In addition, the amount of the resin 170 per discharge is preferably, e.g., not less than 0.01325 mg and not more than 1.89325 mg by weight even though it depends on the type of silicone resin. The specific gravity in this case is not less than 1.09 g/cm³ and not more than 1.24 g/cm³. The lower limit of the discharge amount is set as the minimum value required to sufficiently protect the light-emitting element 13. The upper limit is set as a value at which adjacent sealing members 17 are not contact with each other.

### (Effects of the embodiment)

In the embodiment described above, a combination of the materials of the light-reflective film 16 and the sealing member 17 capable of increasing the contact angle θ of the sealing member 17 with the light-reflective film 16 is adopted and combined with the light-emitting element 13 having the DBR film 14, and it is thereby possible to obtain wide batwing light distribution characteristics.

Although the embodiment of the invention has been described, the invention is not intended to be limited to the embodiment, and the various kinds of modifications can be implemented without departing from the gist of the invention.

For example, for the sealing member, only its lens shape has been mentioned in the above-described embodiment but, e.g., a light shielding portion, etc., may be arranged on the upper surface of the sealing member to suppress brightness at the center of the lens directly above the light-emitting element. The light shielding portion can be easily provided by printing, etc., and when the light shielding portion is formed of a material that absorbs light of the light-emitting element, such as a black material, stray light due to diffuse reflection, etc., can be suppressed and usability of the light-emitting device in application is improved.

In addition, the invention according to claims is not to be limited to the embodiment and examples described above. Further, please note that not all combinations of the features described in the embodiment and examples are necessary to solve the problem of the invention.

### Industrial Applicability

A light-emitting device can be provided which has batwing light distribution characteristics and in which the sealing member of the light-emitting element formed by the dropping has a shape suitable for obtaining the batwing light distribution characteristics, as well as a method for manufacturing the light-emitting device.

### Reference Signs List

- 1: LIGHT-EMITTING DEVICE
- 10: SUBSTRATE
- 13: LIGHT-EMITTING ELEMENT
- 14: DBR FILM
- 16: LIGHT-REFLECTIVE FILM
- 17: SEALING MEMBER
- 170: RESIN

## Claims

1. A light-emitting device, comprising:
a substrate;
a light-emitting element having a DBR film and being mounted on the substrate;
a light-reflective film provided on a surface of the substrate; and
a sealing member that comprises a lens-shaped dropping-formed article to seal the light-emitting element and is provided on the substrate so that an edge of a bottom surface is in contact with an upper surface of the light-reflective film,
wherein a contact angle of the sealing member with the upper surface of the light-reflective film is not less than 40°.

2. The light-emitting device according to claim 1, wherein the light-reflective film comprises a methyl silicone or a silane fluoride, and wherein the sealing member comprises a methyl phenyl silicone with a thixotropic index of not less than 5 in a state before curing, a phenyl silicone with a thixotropic index of not less than 3 in a state before curing, or an organo-modified silicone with a thixotropic index of not less than 2 in a state before curing.

3. The light-emitting device according to claim 1 or 2, wherein, in a relationship between light distribution angle and emission intensity, emission intensity at the light distribution angle of 0° is not more than 90% of emission intensity at a largest peak.

4. The light-emitting device according to any one of claims 1 to 3, wherein the contact angle is not more than 60°.

5. The light-emitting device according to claim 4, wherein the sealing member comprises a methyl phenyl silicone with a thixotropic index of not less than 5 and not more than 7 in a state before curing, a phenyl silicone with a thixotropic index of not less than 3 and not more than 6 in a state before curing, or an organo-modified silicone with a thixotropic index of not less than 2 and not more than 5 in a state before curing.

6. A method for manufacturing a light-emitting device, comprising:
providing a substrate on which a light-emitting element having a DBR film is mounted and a light-reflective film is provided on a surface; and
by dropping and curing a liquid resin on the substrate, forming a lens-shaped sealing member to seal the light-emitting element so that an edge of a bottom surface is in contact with the light-reflective film,
wherein the liquid resin comprises a methyl phenyl silicone with a thixotropic index of not less than 5, a phenyl silicone with a thixotropic index of not less than 3, or an organo-modified silicone with a thixotropic index of not less than 2.

7. The method for manufacturing a light-emitting device according to claim 6, wherein the liquid resin is heated to a temperature lower than a gelation temperature of the liquid resin by just before being dropped on the substrate, and wherein a temperature of the substrate from when the liquid resin is dropped onto the substrate to when it cures is not less than the gelation temperature of the liquid resin.

8. The method for manufacturing a light-emitting device according to claim 7, wherein a temperature of the liquid resin just before being supplied onto the substrate is not less than 40°C and not more than 70°C.

9. The method for manufacturing a light-emitting device according to claim 7 or 8, wherein the temperature of the substrate from when the liquid resin is dropped onto the substrate to when it cures is not more than 150°C.

10. The method for manufacturing a light-emitting device according to any one of claims 6 to 9, wherein the liquid resin comprises a methyl phenyl silicone with a thixotropic index of not less than 5 and not more than 7, a phenyl silicone with a thixotropic index of not less than 3 and not more than 6, or an organo-modified silicone with a thixotropic index of not less than 2 and not more than 5.
